# FASCICULE DE BREVET EUROPEEN

(11) **EP 0 370 442 B1**
(45) Date de publication et mention de la délivrance du brevet: **13.04.1994**
(21) Numéro de dépôt: 89121467.8
(22) Date de dépôt: 20.11.1989
(51) Int. Cl.: H03M 13/22

(54) **Procédé d'établissement d'une suite-pilote inverse pour un désentrelacement utilisé dans une transmission numérique**
Verfahren zur Herstellung einer invertierten Pilotfolge für eine Entschachtelung für eine digitale Übertragung
Method for the establishment of an inverted pilot sequence for a de-interleaving used in a digital transmission

(30) Priorité: 25.11.1988 FR 8815421
(43) Date de publication de la demande: 30.05.1990
(73) Titulaire: ALCATEL TELSPACE, 92734 Nanterre Cédex (FR); ALCATEL N.V., NL-1077 XX Amsterdam (NL)
(72) Inventeur: Darmon, Marc, F-75007 Paris (FR); Sadot, Philippe, F-75011 Paris (FR)
(74) Mandataire: Weinmiller, Jürgen

(56) Documents cités:
- EP-A- 0 232 043
- EP-A- 0 235 477
- DE-A- 2 240 057
- US-A- 4 394 642
- US-A- 4 547 887
- CLARK AND CAIN: "ERROR CORRECTING CODING" 1981, PLENUM PRESS, NEW YORK US, pages 349-352

## Description

La présente invention se rapporte à un procédé d'établissement d'une suite-pilote inverse pour un désentrelacement utilisé dans une transmission numérique.

Lorsque les mots à transmettre sont codés par un code correcteur d'erreurs, un nombre limité de symboles erronés peuvent être corrigés. En revanche, si une majorité du mot est fausse, il n'existe aucun espoir de pouvoir régénérer ce mot. Pour palier à cet inconvénient, il est connu d'utiliser un entrelacement des symboles, par lequel les symboles d'un même mot codé initial sont éparpillés, de sorte qu'un "paquet" d'erreurs ne rend erronné qu'un seul ou peu de symboles dans plusieurs mots différents, considérés après entrelacement. Les mots deviennent alors tous récupérables.

Il existe de nombreux modes d'entrelacement, mais l'invention concerne plus particulièrement un entrelacement-bloc généré par une suite-pilote d'adresses de la façon suivante :

Les symboles sont écrits et lus dans un vecteur de taille donnée. Les adresses de la suite-pilote définissent les endroits sur le vecteur où le prochain symbole à émettre devra être lu et où sera écrit le symbole suivant, symbole qui sera émis à son tour au moment où la même adresse apparaîtra de nouveau dans la suite-pilote.

Par exemple, pour fixer les idées, supposons que ce vecteur contienne six symboles et que l'on veuille émettre la suite : a b c d e f g h i j k l... La suite pilote est une suite de sextuplets. Dans chacun de ces sextuplets, les six adresses 1, 2, 3, 4, 5 et 6 sont choisies une fois et une seule.

Prenons par exemple comme début de la suite-pilote :
2 6 1 5 4 3 4 1 3 6 5 2 4 2 1 6 5 3...
et considérons que les premiers symboles a à f sont déjà dans le registre.

Ce registre est donc rempli ainsi :
a b c d e f
Dans ce cas, le premier des symboles suivants (g) est mis dans le registre à la deuxième place,où se trouve b: b est émis et remplacé par g, puis le second (h) à la sixième (f est émis et remplacé par h), puis le suivant (i) à la première (a est émis et remplacé par i), puis le suivant (j) à la cinquième (e est émis et remplacé par j), puis le suivant (k) en quatrième position dans le registre (d est émis et remplacé par k), et enfin le douzième (l) à la troisième place (c est émis et remplacé par l).

A ce moment là, le registre contient les septième au douzième symboles d'origine dans l'ordre suivant :
i g l k j h
Le prochain et treizième symbole (m) doit être mis dans le registre en quatrième position, puisque 4 est le septième chiffre de la suite-pilote. Comme il y a déjà k à cet endroit, on émet k et on le remplace par m.

Le quatorzième symbole (n) doit être mis en première position, où il y a déjà i : on émet donc i et on écrit n, et ainsi de suite... Le train, dit "suite-canal", de symboles émis lorsque l'entrelacement est réalisé à l'aide de cette suite-pilote est finalement le suivant :
b f a e d c k i l h j g ...

A la réception, il faut, pour récupérer le train de symboles initial, désentrelacer suivant le même schéma, au moyen d'une "suite-pilote inverse" obtenue à partir de la suite-pilote. Cette suite-pilote inverse est unique, mais plusieurs procédés peuvent être conçus pour l'obtenir.

Un procédé simple d'obtention d'une suite-pilote inverse à partir d'une suite-pilote est le suivant :
Les n premiers symboles de la suite-canal ci-dessus définie sont écrits dans un vecteur, ou registre, de réception, de même taille que celui utilisé à l'émission. Dans l'exemple précédent, n est égal à 6, de sorte que l'on écrit les six premiers symboles de la suite-canal dans ce registre-réception.

Le premier élément de la suite-pilote inverse est alors l'adresse, dans ce registre, du plus petit élément du registre (par "plus petit élément", on entend le symbole qui a le plus petit numéro d'ordre dans la suite des symboles correspondant au codage initial, avant entrelacement à l'émission).

On remplace ce plus petit élément par le symbole suivant de la suite-canal, et on pose comme deuxième élément de la suite-pilote inverse l'adresse du plus petit élément du registre ainsi modifié, et ainsi de suite...

Ainsi, pour trouver chaque élément de la suite-pilote inverse, il faut à chaque fois parcourir tout le registre réception pour en trouver le plus petit élément. Lorsque l'on entrelace les symboles non plus avec des registres de six, mais, comme c'est souvent le cas, avec des registres de l'ordre de 10 000 symboles, il est alors nécessaire pour trouver chaque série de 10 000 adresses de la suite-pilote inverse, de parcourir en tout 10 000 fois un registre de 10 000 éléments et l'ordonner chaque fois pour en trouver l'élément le plus petit, ce qui a pour inconvénient d'être particulièrement long.

L'invention vise à remédier à cet inconvénient, et elle permet de diviser par, à titre d'exemple, plusieurs milliers le temps de calcul de la suite-pilote inverse. Le procédé consiste, en divisant la suite-pilote et la suite-pilote inverse en parties successives ayant chacune la taille du vecteur, ou registre, utilisé à l'émission ou à la réception, à obtenir chaque partie de la suite-pilote inverse à partir de la partie précédente de cette suite-pilote inverse et des deux parties correspondantes de la suite-pilote de la manière suivante : le k-ième élément de la N-ième partie de la suite-pilote inverse est déterminé en relevant le rang du k-ième élément de la (N-1)-ième partie de la suite-pilote dans la N-ième partie de la suite-pilote, et en choisissant alors l'élément qui se trouve à ce rang dans la (N-1)-ième partie de la suite-pilote inverse. La première partie de la suite-pilote inverse est, quant à elle, déterminée par un autre procédé, par exemple par celui décrit précédemment et consistant, après avoir écrit dans le registre réception les premiers éléments, dans l'ordre, de la suite-canal, à choisir pour chaque élément de la suite-pilote inverse l'adresse, dans ce registre, du plus petit élément du registre, tout en remplacant alors, dans ce registre, ce plus petit élément par le symbole suivant de la suite canal.

De toute façon, l'invention sera bien comprise, et ses avantages et autres caractéristiques ressortiront, lors de la description suivante d'un exemple non limitatif d'établissement d'une suite-pilote inverse à l'aide de ce procédé.

Cet exemple reprend les données prises ci-dessus, de sorte que les registres, émission d'une part et réception d'autre part, peuvent contenir chacun six symboles. La série de symboles codés à émettre est la suivante : a b c d e f g h i j k l... La suite pilote est la série de sextuplets suivante :
2 6 1 5 4 3 4 1 3 6 5 2...
et la suite-canal est, comme déterminé précédemment, la suivante:
b f a e d c k i l h j g...

Le premier sextuplet de la suite-pilote inverse est tout d'abord obtenu par le procédé, plus simple mais long, décrit précédemment :

Les six premiers symboles :
b f a e d c
de la suite-canal sont tout d'abord écrits dans le registre-réception. Le premier élément de la suite-pilote inverse est l'adresse du plus petit élément, a, de ce registre, donc l'adresse 3.

On lit a et on le remplace par le symbole suivant de la suite-canal, c'est à dire par k.

En appliquant en tout six fois de suite ce procédé, on obtient les six premiers éléments de la suite-pilote inverse, soit :
3 1 6 5 4 2
On peut alors utiliser, pour calculer les éléments suivants de cette suite-pilote inverse, le procédé conforme à la présente invention :
Pour obtenir le septième élément de la suite-pilote inverse, on cherche quel est le rang, dans le deuxième sextuplet de la suite-pilote, du premier élément du premier sextuplet de cette suite-pilote. Ce premier élément est 2, et 2 est à la sixième place dans ce deuxième sextuplet. En conséquence, on prend, pour le premier élément du deuxième sextuplet de la suite-pilote inverse, l'élément de rang 6 du premier sextuplet de cette suite-pilote inverse, c'est-à-dire 2.

Le huitième élément de la suite-pilote inverse est déterminé de la même façon : le deuxième élément de la suite-pilote est 6, et 6 est quatrième dans la deuxième partie (deuxième sextuplet) de cette suite- pilote ; le huitième élément cherché est donc le quatrième élément du premier sextuplet de la suite-pilote inverse, donc 5.

On continue ainsi jusqu'à épuisemnt total de la suite-pilote. La suite-pilote inverse alors obtenue est la suivante :
3 1 6 5 4 2 2 5 1 4 3 6...

Et il est aisé de vérifier que cette suite-pilote inverse est la même que celle que l'on aurait obtenue à l'aide du premier procédé, plus simple mais beaucoup plus long, précédemment décrit.

Comme il va de soi, l'invention n'est pas limitée à l'exemple qui vient d'être décrit. En particulier, la première partie (premier sextuplet dans l'exemple précédent) de la suite-pilote inverse pourrait être obtenue par un autre procédé que le procédé très simple décrit ci-dessus. Le procédé selon la présente invention a pour avantage, par sa rapidité, de permettre l'obtention d'une suite-pilote inverse en temps réel. Il est alors possible de réaliser en temps réel un entrelacement, pseudo-aléatoire ou non, au moyen d'une suite pilote calculée en temps réel, à un débit interessant.

## Revendications

1. Procédé d'établissement d'une suite-pilote inverse pour un désentrelacement utilisé dans une transmission numérique avec entrelacement au moyen d'une suite-pilote, l'entrelacement utilisant un vecteur, ou registre, émission dans lequel les symboles codés sont successivement lus et écrits à l'aide de la suite-pilote, et le désentrelacement utilisant un registre réception de même taille et dans lequel les symboles reçus selon la suite- canal sont successivement lus et écrits à l'aide de la suite-pilote inverse, caractérisé en ce qu'il consiste, en divisant la suite-pilote (2 6 1 5 4 3 4 1 3 6 5 2...) et la suite-pilote inverse en parties successives (2 6 1 5 4 3, 4 1 3 6 5 2,...) ayant chacune la taille dudit registre émission ou réception, à obtenir chaque partie (2 5 1 4 3 6) de la suite-pilote inverse à partir de la partie précédente (3 1 6 5 4 2) de cette suite-pilote inverse et des deux parties correspondantes (2 6 1 5 4 3, 4 1 3 6 5 2) de la suite-pilote, en relevant, pour déterminer le k-ième élément de la N-ième partie de la suite-pilote inverse, le rang du k-ième élément de la (N-1)-ième partie de la suite-pilote dans la N-ième partie de cette suite-pilote, et en choisissant alors l'élément qui se trouve à ce rang dans la (N-1)-ième partie de la suite-pilote inverse, la première partie (2 6 1 5 4 3) de la suite-pilote inverse étant, quant à elle, déterminée par un autre procédé d'établissement d'une suite-pilote inverse

2. Procédé selon la revendication 1, caractérisé en ce que la première partie (3 1 6 5 4 2) de la suite-pilote inverse est déterminée par un autre procédé consistant, après avoir écrit dans le registre réception les premiers éléments dans l'ordre (2 6 1 5 4 3) de la suite-canal, à choisir pour chaque élément de la suite-pilote inverse l'adresse, dans ce registre, du plus petit élément (a, puis b, puis c,...) du registre, tout en remplacant alors, dans ce registre, ce plus petit élément par le symbole suivant (k, puis i, puis l,...) de la suite-canal.

## Claims

1. A method of establishing a deinterleaving inverse pilot sequence for use in digital transmission including interleaving by means of a pilot sequence, with the interleaving using a transmit vector or register from which encoded symbols are read successively and into which they are written successively by means of the pilot sequence, with deinterleaving using a receive register of the same size from which the symbols received from the channel sequence are read in succession and into which they are written in succession using the inverse pilot sequence, the method being characterized in that it consists in dividing the pilot sequence (2 6 1 5 4 3 4 1 3 6 5 2 ...) and the inverse pilot sequence into successive portions (2 6 1 5 4 3, 4 1 3 6 5 2, ...) each having the same size as said transmit or receive register, in obtaining each portion (2 5 1 4 3 6) of the inverse pilot sequence from the preceding portion (3 1 6 5 4 2) of said inverse pilot sequence and from the two corresponding portions (2 6 1 5 4 3, 4 1 3 6 5 2) of the pilot sequence in order to determine the k-th element of the N-th portion of the inverse pilot sequence by observing the rank of the k-th element of the (N-1)-th portion of the pilot sequence in the N-th portion of said pilot sequence, and then selecting the element to be found at this rank in the (N-1)-th portion of the inverse pilot sequence, while the first portion (2 6 1 5 4 3) of the inverse pilot sequence is itself determined by some other method of establishing an inverse pilot sequence.

2. A method according to claim 1, characterized in that the first portion (3 1 6 5 4 2) of the inverse pilot sequence is determined by another method consisting, after the first elements of the channel sequence have been written into the receive register in order (2 6 1 5 4 3), in selecting each element of the inverse pilot sequence as being the address in said register of the smallest element in the register (a, then b, then c, ...), while simultaneously replacing each smallest element in said register by the following symbol (k, then i, then l, ...) from the channel sequence.

## Patentansprüche

1. Verfahren zur Erstellung einer invertierten Pilotfolge für eine Entschachtelung, das bei einer digitalen Übertragung mit Verschachtelung durch eine Pilotfolge verwendet wird, wobei die Verschachtelung einen Sendevektor bzw. ein Senderegister benutzt, in die die kodierten Symbole nacheinander mit Hilfe der Pilotfolge eingelesen und eingeschrieben werden, während die Entschachtelung ein Empfangsregister gleicher Größe benutzt, in welches die gemäß der Kanalfolge empfangenen Symbole mit Hilfe der invertierten Pilotfolge nacheinander ausgelesen und eingeschrieben werden, dadurch gekennzeichnet, daß das Verfahren darin besteht, die Pilotfolge (2 6 1 5 4 3 4 1 3 6 5 2 ...) und die invertierte Pilotfolge in aufeinanderfolgende Abschnitte (2 6 1 5 4 3, 4 1 3 6 5 2, ...) zu unterteilen, von denen jeder die Größe des Senderegisters oder des Empfangsregisters besitzt, jeden Abschnitt (2 5 1 4 3 6) der invertierten Pilotfolge aus dem vorhergehenden Abschnitt (3 1 6 5 4 2. dieser invertierten Pilotfolge und den beiden entsprechenden Abschnitten (2 6 1 5 4 3, 4 1 3 6 5 2) der Pilotfolge zu gewinnen, daß indem Bestimmung des k-ten Element des N-ten Abschnitts der invertierten Pilotfolge der Rang des k-ten Elements des (N-1)ten Abschnitts der Pilotfolge im N-ten Abschnitt der Pilotfolge erfaßt wird, und daß anschließend dasjenige Elements bestimmt wird, das sich im (N-1)ten Abschnitt der invertierten Pilotfolge auf diesem Rang befindet, wobei der erste Abschnitt (2 6 1 5 4 3) der invertierten Pilotfolge seinerseits durch ein anderes Verfahren zur Erstellung einer invertierten Pilotfolge bestimmt wird.

2. Verfahren nach Anspruch 1, dadurch gekennzeichnet, daß der erste Abschnitt (3 1 6 5 4 2) der invertierten Pilotfolge durch ein anderes Verfahren bestimmt wird, das darin besteht, daß nach dem Einschreiben der ersten Elemente in der Reihenfolge (2 6 1 5 4 3) des Empfangskanals in das Empfangsregister für jedes Element der invertierten Pilotfolge in diesem Register die Adresse des kleinsten Elements (a, dann b, dann c, ..) des Registers gewählt wird, wobei dann in diesem Register das betreffende kleinste Element durch das nachfolgende Symbol (k, dann i, dann l ...) der Kanalfolge ersetzt wird.
